# EUROPEAN PATENT SPECIFICATION

(11) **EP 3 547 352 B1**
(45) Date of publication and mention of the grant of the patent: **30.09.2020**
(21) Application number: 18164243.0
(22) Date of filing: 27.03.2018
(51) Int. Cl.: H01L 21/60, B22F 7/06, H05K 3/36, H01L 21/67

(54) **METHOD FOR JOINING TWO JOINING MEMBERS**
VERFAHREN ZUM VERBINDEN ZWEIER VERBINDUNGSELEMENTE
PROCÉDÉ PERMETTANT D'ASSEMBLER DEUX ÉLÉMENTS DE LIAISON

(43) Date of publication of application: 02.10.2019
(73) Proprietor: Infineon Technologies AG, 85579 Neubiberg (DE)
(72) Inventor: Craes, Fabian, 59494 Soest (DE); Otto, Frederik, 45659 Recklinghausen (DE); Stahlhut, Christian, 31737 Rinteln (DE)
(74) Representative: Westphal, Mussgnug & Partner Patentanwälte mbB

(56) References cited:
- EP-A1- 2 530 786
- WO-A2-2013/182591
- JP-A- 2008 112 955
- US-A1- 2004 245 648
- US-A1- 2016 141 264

## Description

### TECHNICAL FIELD

The instant disclosure relates to a method for joining two joining members, in particular for joining two joining members of a power semiconductor module.

### BACKGROUND

Power semiconductor module arrangements often include a base plate within a housing. At least one substrate is arranged on the base plate. A semiconductor arrangement including a plurality of controllable semiconductor components (e.g., two IGBTs in a half-bridge configuration) is usually arranged on each of the at least one substrates. Each substrate usually comprises a substrate layer (e.g., a ceramic layer), a first metallization layer deposited on a first side of the substrate layer and a second metallization layer deposited on a second side of the substrate layer. The controllable semiconductor components are mounted, for example, on the first metallization layer. The second metallization layer is usually attached to the base plate. In many cases today, a sintering process is used when mounting semiconductor components to the substrate. During a sintering process, the components that are to be joined to each other are heated and are pressed together. This generally works very well, even if the semiconductor substrate, the semiconductor components and the sinter layer which is applied between the semiconductor substrate and the semiconductor components each have a different thermal expansion coefficient. This is, because the semiconductor components have a rather small surface area as compared to the semiconductor substrate. However, sintering processes are generally not used for mounting semiconductor substrates to base plates, because the surface area of a semiconductor substrate is generally rather large and may be almost as large as the surface area of a base plate, for example. In this case, the different thermal expansion coefficients of the different components may lead to severe problems when the components are subsequently cooled down after the process of pressing the components together.

Heating the components during the sintering process and subsequently cooling the components may induce mechanical stress to the joining members and to the sinter layer, if the components have different expansion coefficients. This may drastically reduce the lifetime of the semiconductor module, because the sinter layer may be corrupted or the joining members themselves may be severely damaged. Therefore, for rather large joining members, usually sintering processes are not used when forming a connection between the joining members.

Document WO 2013/182591 A2 discloses a bonding agent for bonding two bodies. The bonding agent has a bonding material and a heating material. The heating material has a ferromagnetic material and is embedded in the bonding material in order to heat the latter.

Document EP 2 530 786 A1 discloses a conductive connecting sheet that is composed of a layered body including resin composition layers and a metal layer, and each resin composition layer satisfies the following requirement: in the case where at least a part of metal ball(s) made of the metal material having low melting point is provided within each resin composition layer, the metal ball(s) is heated at a temperature which is a melting temperature thereof or higher according to "test methods for soldering resin type fluxes" defined in JIS Z 3197, and then a wet extension of the metal ball (s) is measured, the wet extension is 37% or more. If the conductive connecting sheet is used for forming connection portions electrically connecting terminals to each other, the connection portions can be formed by selectively aggregating a heated and melted metal material between the terminals and a sealing layer constituted from a resin component can be formed so as to surround the connection portions.

Document JP 2008 112955 A discloses a metal bonding material. The metal bonding material is prepared by mixing bonding metal which can be fused at soldering temperature and positioning metal which is not fused at the soldering temperature and can heat up by induction. The bonding metal is formed in a sheet or tape (ribbon) shape and the positioning metal is in the form of a plurality of grains. The grains are spherical, cubical, polyhedral, and so on such that when the grains are mounted on a plane, they have a nearly constant height irrelevantly to the mounting state. A ferromagnetic material is used as the positioning metal and at least one of Ni, Fe, and Co is used. Solder and a brazing material are usable as the bonding metal and the solder may be either of lead solder and lead-free solder.

Document US 2016/141264 A1 discloses an apparatus for flip chip bonding using conductive and inductive heating to heat a plurality of solder bumps located between a chip carrier and a chip.

There is a need for a method which enables the use of sintering processes for any kind of joining members, independent of the size or the material of the joining members and the connection layer.

### SUMMARY

A method according to the invention is defined in the appended claims and includes arranging a second joining member on a flat contact surface of a first part of a joining arrangement, arranging a first pre-layer on a surface of the second joining member which faces away from the flat contact surface of the first part, wherein the first pre-layer comprises a first sublayer and at least one additional sublayer, arranging a first joining member on the first pre-layer such that the first pre-layer is arranged between the first joining member and the second joining member, applying pressure to the stack comprising the first joining member, the second joining member and the first pre-layer by means of a second part of the joining arrangement, thereby pressing the first joining member on the first pre-layer and the second joining member, and directly heating the first pre-layer without directly heating the joining members, wherein heat in the first pre-layer is generated contactlessly. Contactlessly generating heat in the first pre-layer comprises generating an electromagnetic field. Arranging a first pre-layer on a surface of the second joining member comprises arranging the first sublayer on a surface of the second joining member which faces away from the flat contact surface of the first part, and arranging the at least one additional sublayer on the first sublayer such that the at least one additional sublayer is arranged between the first joining member and the first sublayer, wherein the at least one additional sublayer comprises ferromagnetic or paramagnetic particles, and wherein contactlessly generating heat in the first pre-layer further comprises stimulating the ferromagnetic or paramagnetic particles of the at least one additional sublayer.

An arrangement for joining two joining members, which does not form part of the present invention, includes a first part configured to provide a flat contact surface, a second part configured to apply pressure to at least two joining members arranged on the flat contact surface of the first part with a first pre-layer arranged in between the two joining members, and at least one heating arrangement configured to contactlessly heat the first pre-layer, wherein, when heating the first-pre layer, heat is generated directly within the first-pre layer without directly heating the joining members.

The invention may be better understood with reference to the following drawings and the description. The components in the figures are not necessarily to scale, emphasis is instead being placed upon illustrating the principles of the invention. Moreover, in the figures, like referenced numerals designate corresponding parts throughout the different views.

### BRIEF DESCRIPTION OF THE DRAWINGS

Figure 1 illustrates a cross-sectional view of an arrangement for joining two joining members, which is useful for understanding the present invention.
Figure 2 schematically illustrates a cross-sectional view of an arrangement for joining two joining members according to an example useful for understanding the present invention.
Figure 3 schematically illustrates a cross-sectional view of an arrangement for joining two joining members according to a further example useful for understanding the present invention.
Figure 4, including Figures 4A to 4D, schematically illustrates a method for joining two joining members according to one example useful for understanding the present invention.
Figure 5 schematically illustrates in a cross-sectional view of an arrangement for joining two joining members according to a further example useful for understanding the present invention.
Figure 6, including Figures 6A to 6E, schematically illustrates a method for joining two joining members according to an embodiment of the present invention.
Figure 7 schematically illustrates in a cross-sectional view of an arrangement for joining two joining members according to a further example useful for understanding the present invention.

### DETAILED DESCRIPTION

In the following detailed description, reference is made to the accompanying drawings. The drawings show specific examples in which the invention may be practiced. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or be included in a semiconductor chip. A semiconductor body has electrically connecting pads and includes at least one semiconductor element with electrodes.

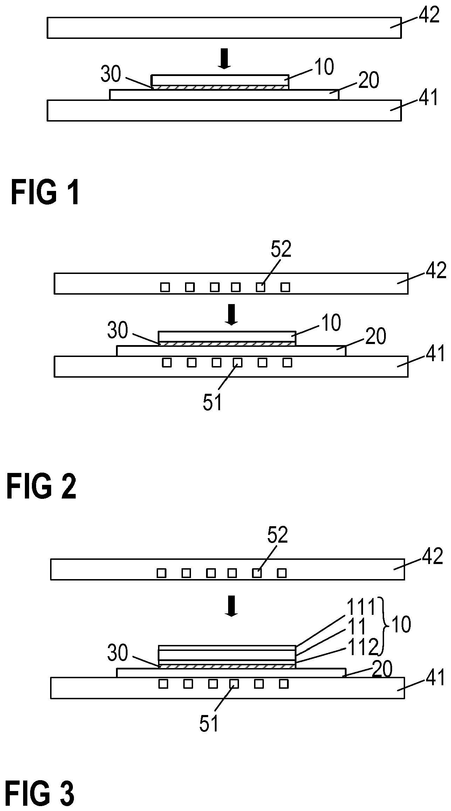

Referring to Figure 1, an arrangement for joining two joining members is illustrated. The arrangement comprises a first part 41 and a second part 42. A first joining member 10 and a second joining member 20 may be arranged on the first part 41, for example. The first part 41 may provide a flat support surface, for example, on which the joining members 10, 20 may be arranged. The second joining member 20 may be arranged on the first part 41, while the first joining member 10 may be stacked on top of the second joining member 20 such that the second joining member is arranged between the first joining member 10 and the first part 41. An electrically conductive connection layer 30 may be arranged between the first joining member 10 and the second joining member 30. The electrically conductive connection layer 30 generally may be a layer of a metal powder, e.g., a silver powder.

The second part 42 may apply pressure to the joining members 10, 20, as is indicated with the arrow in Figure 1. In this way, the first joining member 10 is pressed against the second joining member 20. Usually, the first part 41 and the second part 42 are heated during this so-called sintering process. For example, at least one of the parts 41 and 42 may be heated to up to 100°C, or up to 200°C, or up to 300°C or even more. In this way, the first joining member 10 and the second joining member 20 which are in direct contact with the first part 41 and the second part 42, respectively, are heated by the first part 41 and/or the second part 42 and the heat is further transferred via the joining members 10, 20 to the connection layer 30. The connection layer 30 is compacted during this process and subsequently forms a solid substance-to-substance bond between the two joining members 10, 20. Such sintering processes are generally known and, therefore, will not be described in further detail.

Different joining members often have very different expansion coefficients, because the joining members comprise different materials. A sintered connection layer 30 may have an expansion coefficient of CTE_{Ag} ∼ 19 ppm/K, for example. The expansion coefficient of a (sintered) connection layer 30 usually is considerably higher than the expansion coefficient of a semiconductor body (semiconductor component) and of a conventional semiconductor substrate. For example, the expansion coefficient of a semiconductor body may be CTE_{Chip} ∼ 4 ppm/K, and the expansion coefficient of a semiconductor substrate may be between CTE_{Substrate} ∼ 5 ppm/K and CTE_{Substrate} ∼ 8 ppm/K. The expansion coefficient of a base plate may be between CT_{Eplate} ∼ 15 ppm/K and CTEₚₗₐₜₑ ∼ 24 ppm/K, for example. The given values, however, are only examples. Other values are also possible.

Therefore, when heated, the different joining members 10, 20 as well as the connection layer 30 between the joining members 10, 20 may expand to different degrees. When the components are subsequently cooled down after the sintering process has been completed or after the process of pressing together the joining members has been completed, the different expansion of the components may result in high mechanical stresses which may in turn result in damage of the joining members 10, 20 and/or the connection layer 30. This effect is less severe if one of the joining members 10, 20 is large as compared to the second joining member (e.g., semiconductor body mounted on semiconductor substrate). However, the effect generally significantly increases for joining members that have essentially the same size, which is usually the case with semiconductor substrates that are mounted to a base plate. Therefore, usually the joining members 10, 20 and the connection layer 30 are chosen such that their materials have essentially the same expansion coefficient, which dramatically limits the variety of potential joining members. In other cases, two joining members with different expansion coefficients may be connected to each other using other connecting methods instead of sintering.

Now referring to Figure 2, an arrangement for joining two joining members is exemplarily illustrated, this arrangement not forming part of the claimed invention. As has been described with reference to Figure 1 above, the arrangement comprises a first part 41 and a second part 42. The joining members 10, 20 are arranged on the first part 41 which provides a flat support surface. The second joining member 20 is arranged on the flat support surface of the first part 41, and the first joining member 10 is stacked above the second joining member 20 such that the second joining member 20 is arranged between the first joining member 10 and the first part 41. A connection layer 30 is arranged between the first joining member 10 and the second joining member 20.

The first part 41 comprises a first heating arrangement 51 and the second part 42 comprises a second heating arrangement 52. This, however, is only an example. It is also possible that only the first part 41 comprises a heating arrangement 51 or only the second part 42 comprises a heating arrangement 52. The first and/or second heating arrangement 51, 52 are configured to selectively heat the connection layer 30. "Selectively heat" in this context means, that heat is generated directly in the connection layer 30. This means, that the temperature of the connection layer 30 is significantly higher than the temperature of the first joining member 10 and the second joining member 20. This is in contrast to conventional arrangements that have been explained with respect to Figure 1 above, where heat is generated in the first part 41 and/or the second part 42. In the arrangement of Figure 1, heat is transferred to the connection layer 30 via the first joining member 10 and the second joining member 20. Therefore, in the arrangement of Figure 1, the temperature of the first joining member 10 and the second joining member 20 is generally higher than or the same as the temperature of the connection layer 30. In the arrangement described with respect to Figure 2, on the other hand, only the connection layer 30 is heated. Some of the heat that is generated in the connection layer 30 may be transferred to the adjoining joining members 10, 20, however, the joining members 10, 20 nevertheless warm significantly less than the connection layer 30 and their temperature remains significantly lower than the temperature of the connection layer 30. As the first joining member 10 and the second joining member 20 are warmed up only to a certain degree when using the arrangement according to the present invention, they do not expand as much as with conventional arrangements (see, e.g., Figure 1). Therefore, a mismatch between the expansion coefficients of the different components has no or only little influence on the joining members 10, 20 and the connection layer 30. Mechanical stresses, therefore, are significantly decreased for the arrangement of Figure 2 which results in reduced damages.

The connection layer 30 may be heated contactlessly. This means, that the first heating arrangement 51 and the second heating arrangement 52 are not in direct contact with the connection layer 30. For example, the first heating arrangement 51 and the second heating arrangement 52 may be configured to generate an electromagnetic field and the connection layer 30 may be heated inductively. An induction heater generally comprises an electromagnet and an electronic oscillator that passes highfrequency alternating current through the electromagnet. The rapidly alternating magnetic field penetrates the object, which in this case is the connection layer 30, generating electric currents inside the object. Inductive heating is generally known and, therefore, will not be described in further detail. The first heating arrangement 51, for example, may comprise an inductor coil. Cross sections of such an inductor coil are exemplarily illustrated in Figure 2. The second heating arrangement 52 may also include an inductor coil, for example. Other contactless heating arrangements, however, are also possible.

In order to selectively heat the connection layer 30 using induction, the connection layer 30 may comprise ferromagnetic or paramagnetic particles. For example, the connection layer 30 may comprise a higher percentage of ferromagnetic or paramagnetic particles than each of the joining members 10, 20. In some examples, the joining members 10, 20 do not comprise any ferromagnetic or paramagnetic particles. Sintering pastes which are used for conventional sintering processes are usually not ferromagnetic or paramagnetic and comprise a metal such as silver, gold or copper, for example. According to one example of the present invention, ferromagnetic or paramagnetic particles may be added to such a conventional sintering paste which subsequently forms the connection layer 30 after completing the sintering process. Ferromagnetic particles may comprise, for example, Iron (Fe), Copper (Co), Nickel (Ni), Neodymium (Nd), a ferromagnetic alloy, or a paramagnetic alloy.

The ferromagnetic or paramagnetic particles may be evenly distributed in the connection layer 30. However, it is also possible that the connection layer 30 comprises first regions and second regions, wherein the first regions comprise a higher percentage of ferromagnetic or paramagnetic particles than the second regions. In this way, the local heat generation within the connection layer 30 may be regulated. First and second regions may alternate in a horizontal direction and/or in a vertical direction.

According to one embodiment of the invention, the first joining member 10 is a semiconductor substrate and the second joining member 20 is a base plate. Figure 3 illustrates an example, which is not part of the claimed invention, whereby a semiconductor substrate functions as the first joining member 10. The semiconductor substrate includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminium; an aluminium alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminium oxide; aluminium nitride; zirconium oxide; silicon nitride; boron nitride; or any other dielectric ceramic. For example, the dielectric insulation layer 11 may consist of or include one of the following materials: Al₂O₃, AlN, or Si₃N₄. For instance, the substrate may, e.g., be a Direct Copper Bonding (DCB) substrate, a Direct Aluminium Bonding (DAB) substrate, or an Active Metal Brazing (AMB) substrate. The substrate may also be a conventional printed circuit board (PCB) having a non-ceramic dielectric insulation layer 11. For instance, a non-ceramic dielectric insulation layer 11 may consist of or include a cured resin.

According to an alternative embodiment of the present invention, the first joining member 10 is a semiconductor body and the second joining member 20 is a semiconductor substrate. Usually one or more semiconductor bodies are arranged on a semiconductor substrate. Each of the semiconductor bodies arranged on a semiconductor substrate may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element. One or more semiconductor bodies may form a semiconductor arrangement on the semiconductor substrate.

When mounting the first joining member 10 to the second joining member 20, the joining members 10, 20 are arranged on the flat contact surface of the first part 41 with the connection layer 30 arranged in between the joining members 10, 20, and the first joining member 10 is pressed onto the second joining member 20 by applying force to the joining members 10, 20 by means of the second part 42. The joining members 10, 20 are then permanently attached to each other, and the connection layer 30 provides a stable, substance-to-substance bond between the joining members 10, 20.

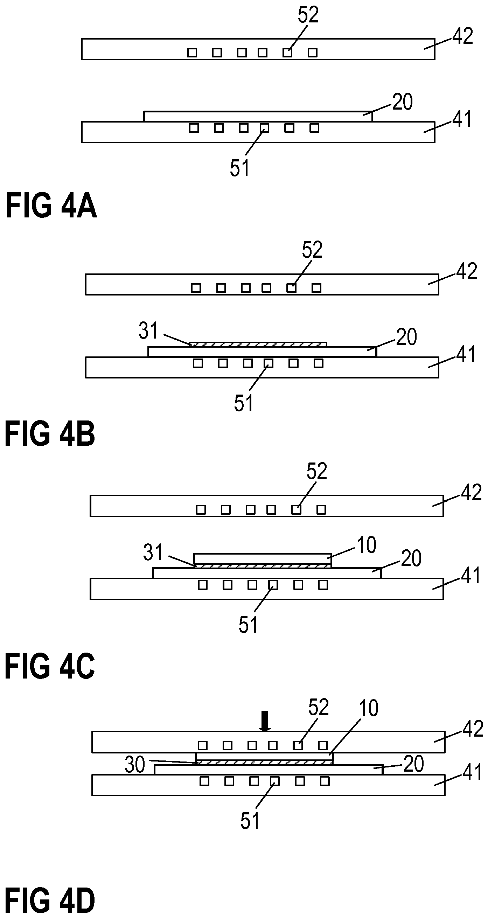

Now referring to Figure 4A, a method, which is not part of the claimed invention, for joining two joining members 10, 20 comprises arranging a second joining member 20 on a flat contact surface of a first part 41. In a following step, a pre-layer 31 may be formed on a top surface of the second joining member 20, as is schematically illustrated in Figure 4B. A top surface of the second joining member 20 is a surface facing away from the first part 41. The pre-layer 31 may be formed by depositing a paste on the top surface of the second joining member 20. The paste may be liquid, viscous or wax-like, for example. Wax-like in this context means that the paste has a similar consistency and hardness as wax. In a following step, the first joining member 10 is arranged on the second joining member 20 with the pre-layer 31 arranged between the first joining member 10 and the second joining member 20, as is schematically illustrated in Figure 4C. Referring to Figure 4D, the second part 42 applies pressure to the stack including the first joining member 10, the second joining member 20 and the pre-layer 31. At the same time, the pre-layer 31 which later forms the connection layer 30 is selectively heated as has been described above. By applying pressure to and heating the pre-layer 31, the pre-layer 31 is compacted and the pre-layer 31 is dried, thereby evaporating some or all of the liquid present in the pre-layer 31. After the compacting and drying step, the resulting connection layer 30, therefore, is no longer liquid, viscous or wax-like. After the compacting and drying step, the connection layer 30 is hardened and forms a firm substance-to-substance bond between the first joining member 10 and the second joining member 20.

The method described with respect to Figure 4 above is only an example. It is, for example, also possible that after forming the pre-layer 31 on the second joining member 20 and before arranging the first joining member 10 on the pre-layer 31, the pre-layer 31 is dried in an intermediate drying step (not specifically illustrated). In such an intermediate drying step, some or all of the liquid of the pre-layer 31 may be evaporated. For example, the pre-layer 31 may be heated to evaporate some or all of the liquid present in the pre-layer 31. The first joining member 10 may subsequently be arranged on the dried pre-layer 31 and the first joining member 10 may be permanently connected to the second joining member 20 as has been described with respect to Figures 4C and 4D above.

In order to pre-dry the pre-layer 31, the pre-layer 31 may be selectively heated, as has been described with respect to Figures 2 and 3 above. This means that the pre-layer 31 may be inductively heated by the first heating arrangement 51 and/or the second heating arrangement 52. The first joining member 10 and the second joining member 20 are not directly heated, as has been described before. In particular, the first joining member 10 and the second joining member 20 are not actively heated, however, heat that is generated in the pre-layer 31 may be transmitted to the first and second joining member 10, 20 to a certain degree.

Alternatively, the pre-layer 31 may be dried in a different process with a different heating principle prior to performing the methods and processes as described herein.

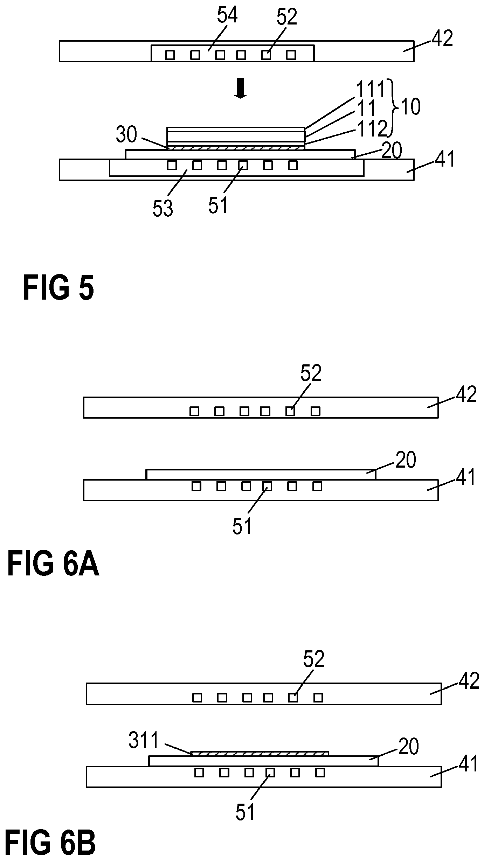

As has been described above, the first heating arrangement 51 and the second heating arrangement 52 may include an inductor structure or an inductor coil, for example. This inductor structure may be configured to generate an electromagnetic field. As is schematically illustrated in Figure 5, the first part 41 and the second part 42 may comprise a material 53, 54 which is transparent for electromagnetic fields. "Transparent for electromagnetic fields" in this context means that electromagnetic fields may penetrate the material almost unhindered. Figure 5 exemplarily illustrates an arrangement wherein the first heating arrangement 51 is embedded in a material 53 that is transparent for electromagnetic fields. Further, in the embodiment illustrated in Figure 5, the second heating arrangement 42 is embedded in a material 54 that is transparent for electromagnetic fields. Each of the first part 41 and second part 42 may at least partly be formed of a material 53, 54 which is transparent for electromagnetic fields.

On the other hand, while being transparent for electromagnetic fields, the first part 41 and the second part 42 still need to have a certain hardness such that they are capable of applying the necessary strength and pressure for pressing the joining members 10, 20 together without the first part 41 and the second part 42 being deformed. For example, the material 53, 54 which is transparent for electromagnetic fields may comprise a glass ceramic. The glass ceramic may comprise Macor (registered trademark), for example.

The first joining member 10 and the second joining member 20 may have a low thermal conductivity. In this way, the joining members 10, 20 remain rather cool, even if the connection layer 30 is heated. Further, the materials used for the first part 41 and the second part 42 may have a low thermal conductivity for the same reasons. According to a further example, the first joining member 10 and the second joining member 20 may be actively cooled in order to keep their temperatures down. For example, the first part 41 and the second part 42 may each comprise a heat sink or a cooling element (not illustrated).

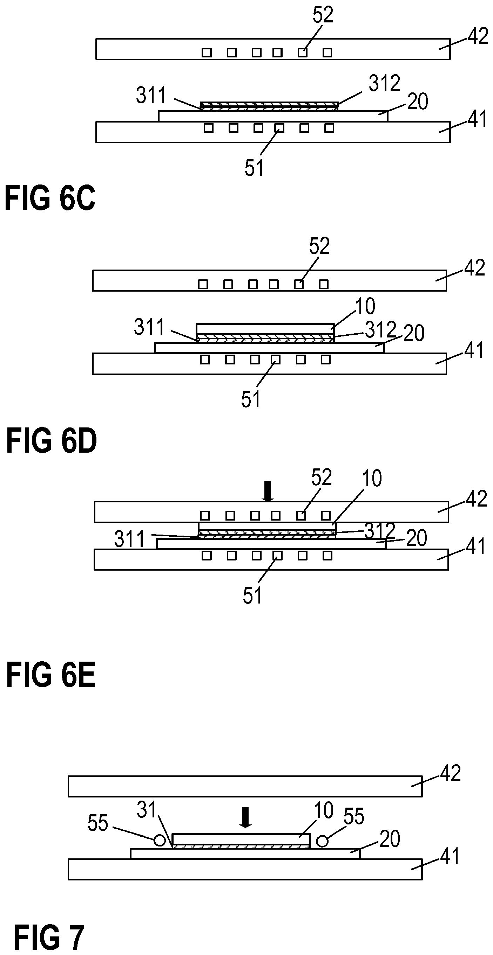

According to an even further example, which is not part of the present invention, a heating arrangement may not be integrated in the first part 41 or the second part 42. As is exemplarily illustrated in Figure 7, a heating arrangement 55 may be arranged to surround the pre-layer 31 or the connection layer 30. The heating arrangement 55 in Figure 7 is not integrated in the first part 41 or the second part 42. The heating arrangement 55 is rather arranged in a space between the first part 41 and the second part 42. The heating arrangement 55 may be arranged in one plane with or slightly set apart from the plane in which the pre-layer 31 or connection layer 30 are arranged. For example, the heating arrangement 55 may comprise an inductor coil that is arranged to surround the pre-layer 31 or connection layer 30 in a horizontal direction. The horizontal direction is a direction parallel to the top surface of the second joining member 20. The heating arrangement 55 may have a height in a vertical direction perpendicular to the horizontal direction and to the top surface of the second joining member 20 which is less than the height of the stack including first joining member 10, the second joining member 20 and the connection layer 30. In this way the second part 42 does not compress the heating arrangement 55 when pressing the first joining member 10 on the second joining member 20. This prevents damages of the heating arrangement 55.

The material of the pre-layer 31 and the resulting connection layer 30 may be chosen such that the electromagnetic field generated by a heating arrangement 51, 52, 55 excites the pre-layer 31 or connection layer 30 more as compared to all other components of the stack (e.g., first joining member 10 and second joining member 20). The frequency of the electromagnetic field is known and, therefore, the material may be chosen such that it couples very effectively with the given frequency of the electromagnetic field. For example, the ferromagnetic or paramagnetic particles that are distributed within the pre-layer 31 and the connection layer 30 may be chosen such that they are stimulated effectively by the electromagnetic field at a given frequency. Heat may be generated within the pre-layer 31 or connection layer 30 through energy losses resulting from the electromagnetic interaction between the electromagnetic field and the particles of the pre-layer 31 or connection layer 30. The energy losses within the pre-layer 31 or connection layer 30 may be maximized by choosing the material of the pre-layer 31 or connection layer 30 appropriately. Energy losses may be generated by absorption or radiation of electromagnetic fields, for example. The electromagnetic field generated by a heating arrangement 51, 52, 55 may trigger energy losses resulting from phase transitions or modifications of the atomic, molecular or electronic structure within the pre-layer 31 or connection layer 30.

If the particles in the pre-layer 31 or connection layer 30 are stimulated by the electromagnetic field to a high degree, while at the same time the material of the first joining member 10 and the second joining member 20 are not stimulated at all or only to a very low degree as compared to the pre-layer 31 or connection layer 30, the heating of the pre-layer 31 or connection layer 30 is very efficient while the temperature of the joining members 10, 20 may be kept comparably low.

As has been described above, ferromagnetic particles may be evenly distributed within the pre-layer 31 or connection layer 30. This, however, is only an example. According to the present invention, the pre-layer 31 comprises a first sublayer 311 and at least one additional sublayer 312. A second joining member 20 may be arranged on the first part 41 (see Figure 6A) and a first sublayer 311 is formed on the second joining member 20 by applying a conventional sinter paste such as a silver paste, a copper paste or a gold paste, for example, without any ferromagnetic particles (see Figure 6B). An additional sublayer 312 including ferromagnetic particles is then formed on the first sublayer 311, as is illustrated in Figure 6C. The first sublayer 311 may be dried before forming the additional sublayer 312. According to a further example, the first sublayer 311 may be dried after forming the additional sublayer 312. A first joining member 10 is then arranged on the additional sublayer 312 (see Figure 6D). The ferromagnetic particles of the additional sublayer 312 are then stimulated in the way as has been described above, thereby also heating the adjoining first sublayer 311 while pressing the first joining member 10 on the second joining member 20 (see Figure 6E). If the first joining member 10 has a low thermal conductivity or is actively cooled, the pre-layer 31 is heated more than the first joining member 10. The same applies for the second joining member 20.

According to one example, the particles within the additional sublayer 312 may be arranged in a specific geometric pattern which allows for a locally different heat generation in the first sublayer 11, the first joining member 10 and the second joining member 20. Such geometric patterns could be used for locally controlling modifications of the material properties of the first sublayer 311 and the joining members 10, 20.

A penetration depth of the electromagnetic field may be adapted by appropriately choosing the distance between the heating arrangement 51, 52, 55 and the pre-layer 31, connection layer 30 or additional sublayer 312. The penetration depth is a depth which the electromagnetic field penetrates into the respective layer 30, 31, 312. The stronger the electromagnetic field, the deeper does the electromagnetic field penetrate into the respective layer 30, 31, 312, and the lower the electromagnetic field, the less deep does the electromagnetic field penetrate into the respective layer 30, 31, 312. The strength of the electromagnetic field inter alia depends on the distance to the source of the field. Therefore, if the respective layer 30, 31, 312 is arranged further away from the respective heating arrangement 51, 52, 55 which is the source of the electromagnetic field, the penetration depth is small. The closer the respective layer 30, 31, 312 is arranged to the respective heating arrangement 51, 52, 55, the deeper the penetration depth.

The penetration depth may further by adapted by appropriately setting the frequency of the electromagnetic field. The frequency of the electromagnetic field may be between 10kHz and 100kHz, for example.

The heating of the respective layer 30, 31, 312 may further be influenced by the size or the shape of the ferromagnetic particles, for example. Ferromagnetic particles of different size or different shape may be stimulated differently by the electromagnetic field. According to a further example, ferromagnetic particles of a first size and shape and ferromagnetic particles of a second size and shape may be distributed within the respective layer 30, 31, 312. Ferromagnetic particles with different shapes and sizes may be evenly distributed within the respective layer 30, 31, 312. It is, however, also possible that there are first regions comprising ferromagnetic particles of a first size and shape and second regions comprising ferromagnetic particles of a second size and shape. In this way, the local properties of the respective layer 30, 31, 312 may be tuned to optimally heat the layer 30, 31, 312.

For example, it is possible to form a first additional sublayer 312 on the first sublayer 311 comprising a first concentration of ferromagnetic particles, and to form at least one further additional sublayer comprising a different concentration of ferromagnetic particles adjacent to the first additional sublayer 312. According to an even further example, a first additional sublayer 312 comprising ferromagnetic particles of a first size and shape is formed on the first sublayer 311, and at least one further additional sublayer comprising ferromagnetic particles of a different size and shape is formed adjacent the first additional sublayer 312.

According to one example, the first heating arrangement 51 and the second heating arrangement 52 generate electromagnetic fields having identical frequencies. According to another example, the first heating arrangement 51 may generate an electromagnetic field having a different frequency than the electromagnetic field generated by the second heating arrangement 52. According to an even further example, the first heating arrangement 51 and/or the second heating arrangement 52 comprise two or more emitters, each emitter generating an electromagnetic field with a different frequency. The different electromagnetic fields stimulate the ferromagnetic particles to different degrees and the different frequencies result in different penetration depths of the electromagnetic fields.

According to a further example, the arrangement comprising the first part 41 and the second part 42 may be placed in a pressure chamber (not illustrated). The first and second joining members 10, 20 may be arranged on the first part 41 as has been described above with a pre-layer 31 arranged between the first and second joining member 10, 20. The step of pressing the first joining member 10 on the second joining member 20 may be performed in a vacuum or in an inert or in a chemically reactive atmosphere that is generated in the pressure chamber.

It is to be understood that the examples of Figures 2 and 7, which do not form part of the claimed invention, may, for example, may be combined with each other such that the arrangement comprises three heating arrangements 51, 52, 55.

## Claims

1. A method for joining a first and a second joining member, the first and the second joining member being, respectively, a semiconductor substrate and a base plate or a semiconductor body and a semiconductor substrate, the method comprising:
arranging a second joining member (20) on a flat contact surface of a first part (41) of a joining arrangement;
arranging a first pre-layer (31) on a surface of the second joining member (20) which faces away from the flat contact surface of the first part (41) wherein the first pre-layer (31) comprises a first sublayer (311) and at least one additional sublayer (312);
arranging a first joining member (10) on the first pre-layer (31) such that the first pre-layer (31) is arranged between the first joining member (10) and the second joining member (20);
applying pressure to the stack comprising the first joining member (10), the second joining member (20) and the first pre-layer (31) by means of a second part (42) of the joining arrangement, thereby pressing the first joining member (10) on the first pre-layer (31) and the second joining member (20); and
directly heating the first pre-layer (31) without directly heating the joining members (10, 20), wherein heat in the first pre-layer (31) is generated contactlessly, wherein
contactlessly generating heat in the first pre-layer (31) comprises generating an electromagnetic field, and
arranging a first pre-layer (31) on a surface of the second joining member (20) comprises:
arranging the first sublayer (311) on a surface of the second joining member (20) which faces away from the flat contact surface of the first part (41); and
arranging the at least one additional sublayer (312) on the first sublayer (311) such that the at least one additional sublayer (312) is arranged between the first joining member 10 and the first sublayer (311), wherein the at least one additional sublayer (312) comprises ferromagnetic or paramagnetic particles, and wherein contactlessly generating heat in the first pre-layer (31) further comprises stimulating the ferromagnetic or paramagnetic particles of the at least one additional sublayer (312).

2. The method of claim 1, wherein the ferromagnetic or paramagnetic particles are distributed evenly within the additional sublayer (312).

3. The method of claim any of claims 1 to 2, wherein the ferromagnetic or paramagnetic particles are arranged in a defined geometric pattern within the at least one additional sublayer (312), the defined geometric pattern allowing for a locally different heat generation in the first sublayer (311), the first joining member (10) and the second joining member (20), such that the local material properties of at least one of the first sublayer (311), the first joining member (10), and the second joining member (20) are maintained or modified.

4. The method of any of claims 1 to 3 , wherein the ferromagnetic or paramagnetic particles comprise at least one of Iron (Fe), Copper (Co), Nickel (Ni), Neodymium (Nd), and a ferromagnetic alloy.

5. The method of any of claims 1 to 4, wherein heat that is generated in the first pre-layer (31) is transmitted to the first part (41) and the second part (42), thereby increasing the temperature of the first part (41) and the second part (42).

6. The method of claim 5, further comprising cooling the first part (41) and the second part (42) such that a temperature of the first part (41) and the second part (42) is less than a temperature of the first pre-layer (31).

7. The method of any of the preceding claims, wherein the pre-layer (31) comprises liquid, and wherein the method further comprises
removing at least part of the liquid from the pre-layer (31) before arranging the first joining member (10) on the first pre-layer (31).

## Patentansprüche

1. Verfahren zum Verbinden eines ersten und eines zweiten Verbindungselements, wobei das erste und das zweite Verbindungselement jeweils ein Halbleitersubstrat und eine Basisplatte oder ein Halbleiterkörper und ein Halbleitersubstrat sind, wobei das Verfahren umfasst:
Anordnen eines zweiten Verbindungselements (20) auf einer flachen Kontaktoberfläche eines ersten Teils (41) einer Verbindungsanordnung;
Anordnen einer ersten Vorschicht (31) auf einer Oberfläche des zweiten Verbindungselements (20), die von der flachen Kontaktoberfläche des ersten Teils (41) weg weist, wobei die erste Vorschicht (31) eine erste Subschicht (311) und mindestens eine zusätzliche Subschicht (312) umfasst;
Anordnen eines ersten Verbindungselements (10) auf der ersten Vorschicht (31), so dass die erste Vorschicht (31) zwischen dem ersten Verbindungselement (10) und dem zweiten Verbindungselement (20) angeordnet ist;
Ausüben von Druck auf den Stapel, der das erste Verbindungselement (10), das zweite Verbindungselement (20) und die erste Vorschicht (31) umfasst, mittels eines zweiten Teils (42) der Verbindungsanordnung, wodurch das erste Verbindungselement (10) auf die erste Vorschicht (31) und das zweite Verbindungselement (20) gepresst wird; und
direktes Erwärmen der ersten Vorschicht (31) ohne direktes Erwärmen der Verbindungselemente (10, 20), wobei Wärme in der ersten Vorschicht (31) kontaktlos generiert wird, wobei
kontaktloses Generieren von Wärme in der ersten Vorschicht (31) Generieren eines elektromagnetischen Felds umfasst, und
Anordnen einer ersten Vorschicht (31) auf einer Oberfläche des zweiten Verbindungselements (20) umfasst:
Anordnen der ersten Subschicht (311) auf einer Oberfläche des zweiten Verbindungselements (20), die von der flachen Kontaktoberfläche des ersten Teils (41) weg weist; und
Anordnen der mindestens einen zusätzlichen Subschicht (312) auf der ersten Subschicht (311), so dass die mindestens eine zusätzliche Subschicht (312) zwischen dem ersten Verbindungselement (10) und der ersten Subschicht (311) angeordnet ist, wobei die mindestens eine zusätzliche Subschicht (312) ferromagnetische oder paramagnetische Partikel umfasst, und wobei kontaktloses Generieren von Wärme in der ersten Vorschicht (31) des Weiteren Stimulieren der ferromagnetischen oder paramagnetischen Partikel der mindestens einen zusätzlichen Subschicht (312) umfasst.

2. Verfahren nach Anspruch 1, wobei die ferromagnetischen oder paramagnetischen Partikel gleichförmig innerhalb der zusätzlichen Subschicht (312) verteilt sind.

3. Verfahren nach einem der Ansprüche 1 bis 2, wobei die ferromagnetischen oder paramagnetischen Partikel in einem definierten geometrischen Muster innerhalb der mindestens einen zusätzlichen Subschicht (312) angeordnet sind, wobei das definierte geometrische Muster eine lokal unterschiedliche Wärmegenerierung in der ersten Subschicht (311), dem ersten Verbindungselement (10) und dem zweiten Verbindungselement (20) zulässt, so dass die lokalen Materialeigenschaften von mindestens einer von der ersten Subschicht (311), dem ersten Verbindungselement (10) und dem zweiten Verbindungselement (20) aufrechterhalten oder modifiziert werden.

4. Verfahren nach einem der Ansprüche 1 bis 3, wobei die ferromagnetischen oder paramagnetischen Partikel mindestens eines von Eisen (Fe), Kupfer (Co), Nickel (Ni), Neodym (Nd) und einer ferromagnetischen Legierung umfassen.

5. Verfahren nach einem der Ansprüche 1 bis 4, wobei Wärme, die in der ersten Vorschicht (31) generiert wird, auf das erste Teil (41) und das zweite Teil (42) übertragen wird, wodurch die Temperatur des ersten Teils (41) und des zweiten Teils (42) erhöht wird.

6. Verfahren nach Anspruch 5, des Weiteren umfassend Kühlen des ersten Teils (41) und des zweiten Teils (42), so dass eine Temperatur des ersten Teils (41) und des zweiten Teils (42) kleiner als eine Temperatur der ersten Vorschicht (31) ist.

7. Verfahren nach einem der vorhergehenden Ansprüche, wobei die Vorschicht (31) Flüssigkeit umfasst, und wobei das Verfahren des Weiteren Entfernen von mindestens einem Teil der Flüssigkeit von der Vorschicht (31) umfasst, bevor das erste Verbindungselement (10) auf der ersten Vorschicht (31) angeordnet wird.

## Revendications

1. Procédé pour joindre un premier élément de jonction et un deuxième élément de jonction, les premier et deuxième éléments de jonction étant, respectivement, un substrat à semi-conducteur et une plaque de base ou un corps à semi-conducteur et un substrat semi-conducteur, le procédé comportant les états dans lesquels :
on dispose un deuxième élément (20) de jonction sur une surface de contact plane d'une première partie (41) d'un agencement de jonction ;
on dispose une première pré-couche (31) sur une surface du deuxième élément (20) de jonction qui est tournée dans la direction qui s'éloigne de la surface de contact plane de la première partie (41), dans lequel la première pré-couche (31) comporte une première sous-couche (311) et au moins une sous-couche (312) supplémentaire ;
on dispose un premier élément (10) de jonction sur la première pré-couche (31) de sorte que la première pré-couche (31) est disposée entre le premier élément (10) de jonction et le deuxième élément (20) de jonction ;
on applique de la pression à la pile comportant le premier élément (10) de jonction, le deuxième (20) de jonction et la première pré-couche (31) au moyen d'une deuxième partie (42) de l'agencement de jonction, en pressant ainsi le premier élément (10) de jonction sur la première pré-couche (31) et le deuxième élément (20) de jonction ; et
on chauffe directement la première pré-couche (31) sans chauffer directement les éléments (10, 20) de jonction, dans lequel de la chaleur dans la première pré-couche (31) est produite à la manière sans contact, dans lequel
l'étape de production de la chaleur d'une manière sans contact dans la première pré-couche (31) comporte le fait de produire un champ électromagnétique, et
disposer une première pré-couche (31) sur une surface du deuxième élément (20) de jonction comporte :
disposer la première sous-couche (311) sur une surface du deuxième élément (20) de jonction tournée dans une direction qui s'éloigne de la surface de contact plane de la première partie (41) ; et
disposer la au moins une sous-couche (312) supplémentaire sur la première sous-couche (311) de sorte que la au moins une sous-couche (312) supplémentaire est disposée entre le premier élément (10) de jonction et la première sous-couche (311), dans lequel la au moins une sous-couche (312) supplémentaire comporte des particules ferromagnétiques ou paramagnétiques, et dans lequel l'étape de production à la manière sans contact de chaleur dans la première pré-couche (31) comporte, en outre, l'étape de stimulation des particules ferromagnétiques ou paramagnétiques de la au moins une sous-couche (312) supplémentaire.

2. Procédé suivant la revendication 1, dans lequel les particules ferromagnétiques ou paramagnétiques sont réparties de manière uniforme à l'intérieur de la sous-couche (312) supplémentaire.

3. Procédé suivant l'une quelconque des revendications 1 à 2, dans lequel les particules ferromagnétiques ou paramagnétiques sont agencées suivant une configuration géométrique définie à l'intérieur de la au moins une sous-couche (312) supplémentaire, la configuration géométrique définie permettant une production de chaleur localement différente dans la première sous-couche (311), le premier élément (10) de jonction et le deuxième élément (20) de jonction, de sorte que les propriétés locales de matériau d'au moins l'un de la première sous-couche (311) du premier élément (10) de jonction et du deuxième élément (20) de jonction sont maintenues ou modifiées.

4. Procédé suivant l'une quelconque des revendications 1 à 3, dans lequel les particules ferromagnétiques ou paramagnétiques comporte au moins l'un du fer (Fe), du cuivre (Co), du nickel (Ni), du néodyme (Nd) et d'un alliage ferromagnétique.

5. Procédé suivant l'une quelconque des revendications 1 à 4, dans lequel de la chaleur qui est produite dans la première pré-couche (31) est transmise à la première partie (41) et la deuxième partie (42), augmentant ainsi la température de la première partie (41) et de la deuxième partie (42).

6. Procédé suivant la revendication 5, comportant, en outre, l'étape dans laquelle on refroidit la première partie (41) et la deuxième partie (42) de sorte qu'une température de la première partie (41) et de la deuxième partie (42) est inférieure à une température de la première pré-couche (31).

7. Procédé suivant l'une quelconque des revendications précédentes, dans lequel la pré-couche (31) comporte du liquide et dans lequel le procédé comporte, en outre, l'étape dans laquelle on élimine au moins une partie du liquide de la pré-couche (31) avant de disposer le premier élément (10) de jonction sur la première pré-couche (31).
